# EUROPEAN PATENT SPECIFICATION

(11) **EP 0 640 041 B1**
(45) Date of publication and mention of the grant of the patent: **09.10.1996**
(21) Application number: 92918482.8
(22) Date of filing: 07.08.1992
(51) Int. Cl.: B32B 31/20, B32B 31/04, B32B 15/08, H05K 3/00

(54) **PROCESS FOR PRODUCING PLASTIC LAMINATES WITH METAL LAMINAE, ESPECIALLY FOR PRINTED CIRCUITS**
VERFAHREN ZUR HERSTELLUNG VON PLASTIKLAMINATEN MIT METALLSCHICHTEN INSBESONDERE FÜR GEDRUCKTE SCHALTUNGEN
PROCEDE DE PRODUCTION DE STRATIFIES EN PLASTIQUE A LAMELLES METALLIQUES, NOTAMMENT POUR CIRCUITS IMPRIMES

(30) Priority: 05.05.1992 IT MI921060; 09.07.1992 IT MI300006
(43) Date of publication of application: 01.03.1995
(73) Proprietor: CEDAL S.R.L., I-20148 Milano (IT)
(72) Inventor: CERASO, Bruno, I-20148 Milano (IT); STABILE, Aldo, I-26013 Crema (IT)
(74) Representative: Filippi, Remo
(86) International application number: PCT/IT92/00101
(87) International publication number: WO 93/22139

(56) References cited:
- DE-A- 3 539 990
- US-A- 3 969 177
- PATENT ABSTRACTS OF JAPAN, unexamined applications, M field, vol. 10, no. 2, January 8, 1986 THE PATENT OFFICE JAPANESE GOVERNMERNT page 33 M 444 No. 60-166 428 (MATSUSHITA), see totality

## Description

The invention concerns the processes for production of plastic laminates with metal laminae.

Generally speaking, plastic laminates consist of sheets formed of several layers of plastic materials, associated together in a stable manner, usually by pressing, on a base of paper, fabrics, fibreglass or other materials.

The plastic materials may be of phenol, melamine, epoxy, polyester, silicon, fluoride or others.

In the production of printed circuits a metal lamina, usually of copper, is made to adhere to one or both sides during the pressing process.

A pile of packages, all virtually the same, is formed each of these comprising a number of sheets, impregnated with plastic materials, and copper laminae one of which is placed on each side of the package.

A sheet of metal, stainless steel or some other kind, is placed between each package, and the pile so formed is put inside a multiple-plate press that provides heat and pressure simultaneously.

When each heat cycle, in which a temperature of 190°C may be reached at pressures of up to 100 kg/cm², lasting over 100 minutes and including a cooling stage down to 70-80°C, has been terminated, a compact and rigid product is obtained whose single components are closely associated.

Presses suited to this kind of production must necessarily be complex and will give a low output due to having many heating plates, to having to produce heat and pressure at the same time in well-defined and accurate sequences, to their needing to create, by conduction, uniform temperatures throughout the various packages in the pile of which obviously only those at the top and bottom will be in contact with the heating plates.

Particularly, the propagation of calories from the press's heating plates to the piled up packages, and of units of refrigeration during the cooling stage, is greatly hindered by having to pass through components made of fibreglass impregnated with plastic materials, or others equally insulating materials, which are known to be very poor conductors of heat, in the packages above and below such material in the pile.

In addition to complicating the structure of the press, the presence of many heating plates slows down loading and unloading of packages, while problems are created for short runs of production these being relatively more costly.

Subject of the invention is a process for production of plastic laminates with metal laminae, especially for printed circuits, which comprises formation of piles of packages each one having a number of support sheets, impregnated with plastic material,and metal laminae on one or both faces.

Said metal laminae are rolled off a continuous band.

An initial length of metal band is made to match up with the lower face of the first set of sheets, starting from below. After a fold at 180° has been made a second length of band is laid on the upper face of said set and after placing there a metal sheet and making a second fold at 180°, in the opposite direction to that of the first, a third length is matched up with the lower face of the second set of sheets.

After making a third fold at 180° in the direction opposite to that of the second fold, the band is passed onto the upper face of this last set of sheets, and so on until the upper face of the last set of sheets is reached.

The two ends of the band are connected to a suitably powered generator of electricity.

Therefore by creating adequate pressure on the pile of packages and closing the electric circuit of the generator, the various lengths of band matching with the faces of the packages, act as electric resistances so that close association is made among the various component parts of the package and plastic laminates are duly formed.

The metal band is preferably a copper band.

The required pressure on the pile of packages can be obtained by putting the pile inside a cold press or else in an autoclave.

In accordance with a preferred method each pile of packages is placed inside a die which has an upper and a lower plate connected by guiding and supporting pins.

In this way the pressure needed can be applied in said die.

Pressure on the die can be determined by putting it inside a cold press or in an autoclave.

The invention offers many advantages.

As the presses do not have to provide heat and pressure simultaneously, they can be simpler, and various kinds of presses can be used which are able to generate adequare pressure.

Heating is generated at each single package and an even temperature can be reached within a short time.

Runs of products can be either long or short.

As the various copper laminae in each package can be supplied in the form of a continuous band, cooling times are also considerably reduced.

Both heating and cooling are therefore more quickly done since propagation of calories or of refrigeration units is not impeded in each package by components of fibreglass or other supporting material impregnated with plastic materials which are well known to be very poor heat conductors, in the packages above and below as happens with processes at present in use.

In the event of combined forms of heating being used - the conventional kind by heating plates at each end of the pile of packages and the direct kind through the copper bands - heating times will of course be still further reduced and productivity increased.

Work cycles will be speeded up and simplified so that costs will be lowered.

Characteristics and purposes of the invention will be made still clearer by the following example of its execution illustrated by diagrammatically drawn figures.
- Fig. 1: A present type of multi-plate press for simultaneous production of heat and pressure containing packages wherewith to make laminates for printed circuits by means of methods in use at present.
- Fig.2: A pile of packages formed using the process subject of the present invention.
- Fig.3: A pile of packages, as in Fig. 2, put in a die.
- Fig.4: The die in Fig. 3 placed inside a cold press.
- Fig.5: A pile of packages placed inside an open autoclave.
- Fig.6: The same as Fig. 5 but in a closed autoclave.
- Fig.7: Heat propagation in the pile of packages in Fig.1.
- Fig.8: Heat propagation in the pile of packages in Fig.2.

The multi-plate press 10 has heating plates 11 between which the piles 16 of packages 12 are placed.

Said packages 12 are composed of sheets 13 of fibreglass fabric impregnated with epoxy resins and the copper laminae 14.

Steel sheets 15 are placed between one package and another.

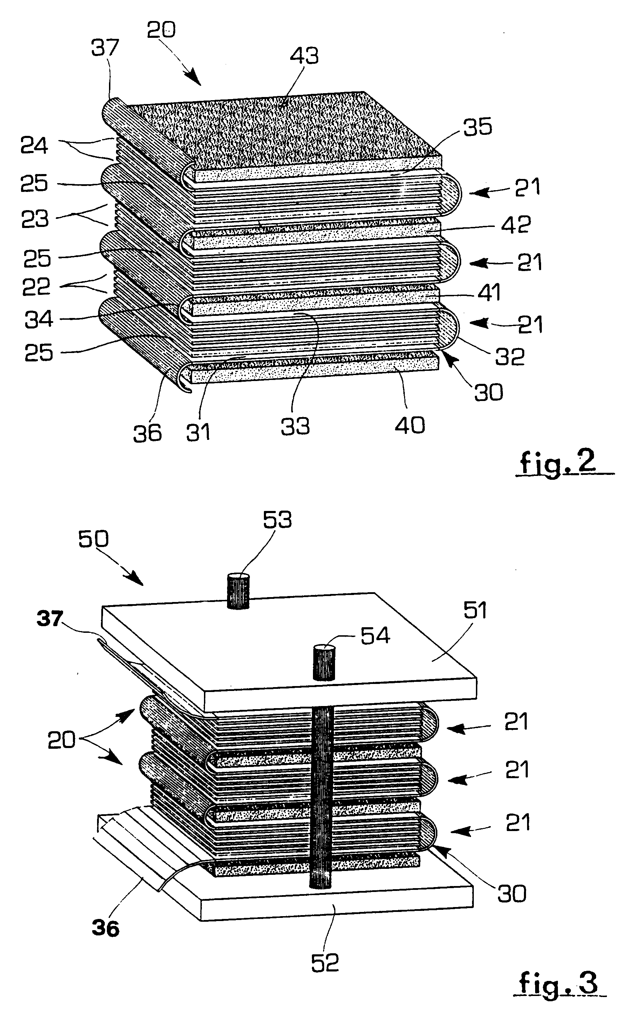

In the pile 20 in Fig. 2 the packages 21 are composed of groups 22-24 of fibreglass sheets 25 impregnated with epoxy resin.

The continuous copper band 30 winds S-wise between one group and another.

Steel sheets 40-43 are inserted between packages.

As illustrated, the first length 31 of band 30 is laid above the first steel sheet 40.

When the group 22 of sheets 25 of fibreglass fabric has been deposited, the band makes a 180° bend 32 in order to deposit the length 33 on the upper face of the last sheet of group 22.

Having placed the second steel sheet 41 on the band, said band makes another bend 34 in the direction opposite to the first one so as to match with the upper face of said steel sheet 41, and so on until the top length 35 is placed and the steel sheet 43 put over it.

The initial and final ends 36 and 37 are allowed to project outwards.

The pile 20 so formed is put into a die 50 between the plates 51 and 52 connected by the two pins 53 and 54 as seen in Fig. 3 where the ends 36 and 37 are shown as projecting further out.

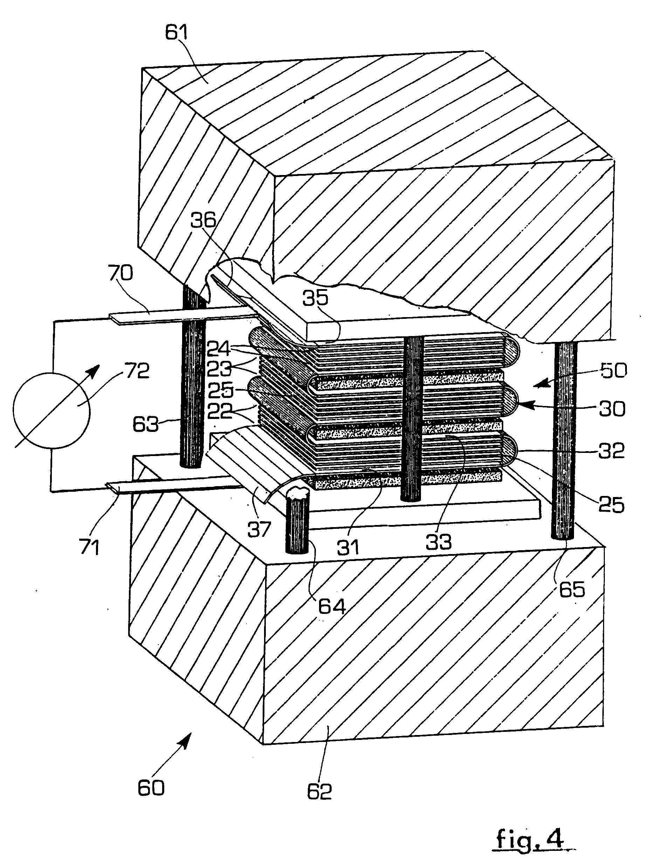

In Fig. 4 there is a diagram of a cold hydraulic press 60 with top and bottom plates 61 and 62 connected and guided by four columns, only three of which, 63-65, are exemplified in the drawing at the four corners.

This press is useful only to compress piled up packages.

The above and lower die 50, 52 are placed between the plates 61 and 62, respectively. The ends 36 and 37 of the band 30 are joined toconductors 70 and 71 connected to a generator 72 of electricity.

On closing the electric circuit the whole band acts like an electric resistance and all its lengths, such as 31, 33, 35, give off direct heat to groups 22-24 of fibreglass sheets 25 and this, added to simultaneous pressure from the press, gives rise to the pressing process.

Cuts are then made at bends 32, 34 and the others between the various lengths of band 31, 33, 35 providing laminates for printed circuits simply and quickly.

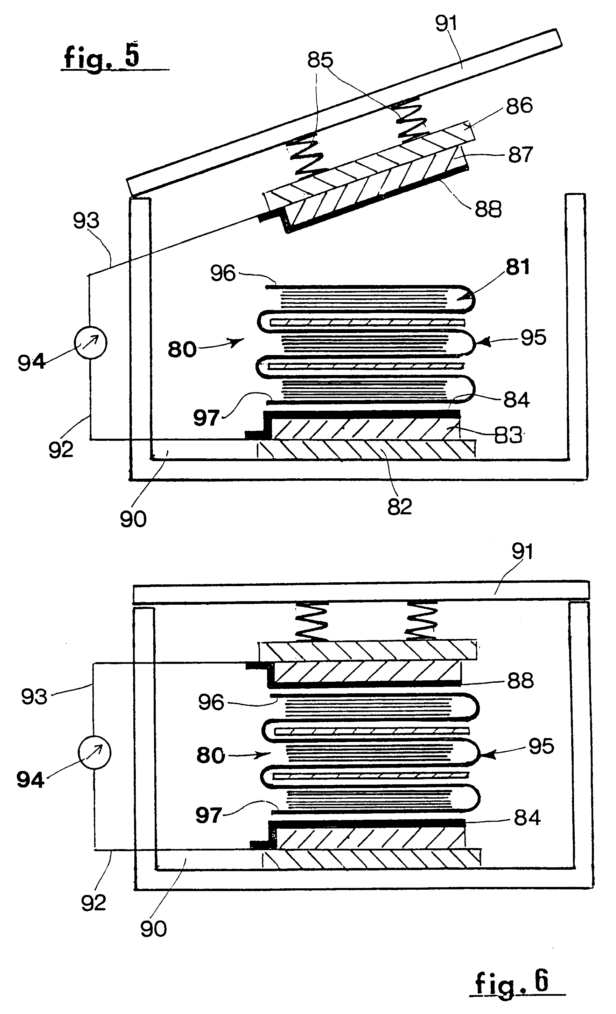

Fig. 5 shows a pile 80 of packages similar to the pile 20 already seen in Figs. 2-4, put inside an autoclave 90.

On the bottom 82 of the autoclave there is a plate 83 covered with a conducting lamina 84.

To the cover 91 of said autoclave a second plate 86 is fixed by means of elastic devices 85,and to it is fixed a plate 87 covered with a conducting lamina 88, so that packages 81 are formed. The laminae 84 and 88 are joined to a generator 94 of electricity of suitable power by means of elastic conductors, a lower one 92 and an upper one 93.

As will be seen in Fig. 6, when the lid is closed, the lamina 88 coincides with the end 96 of the metal band 95.

As the other end 97 of said band matches with the lamina 84, closure of said lid determines closure of the circuit between the generator and the band, and therefore the beginning of the pressing process as previously described.

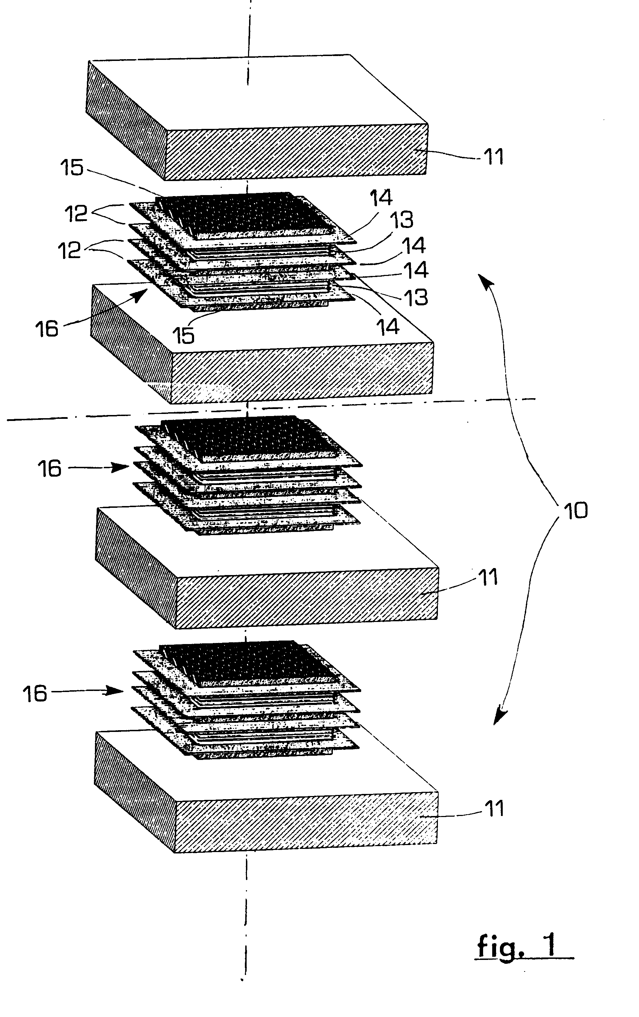

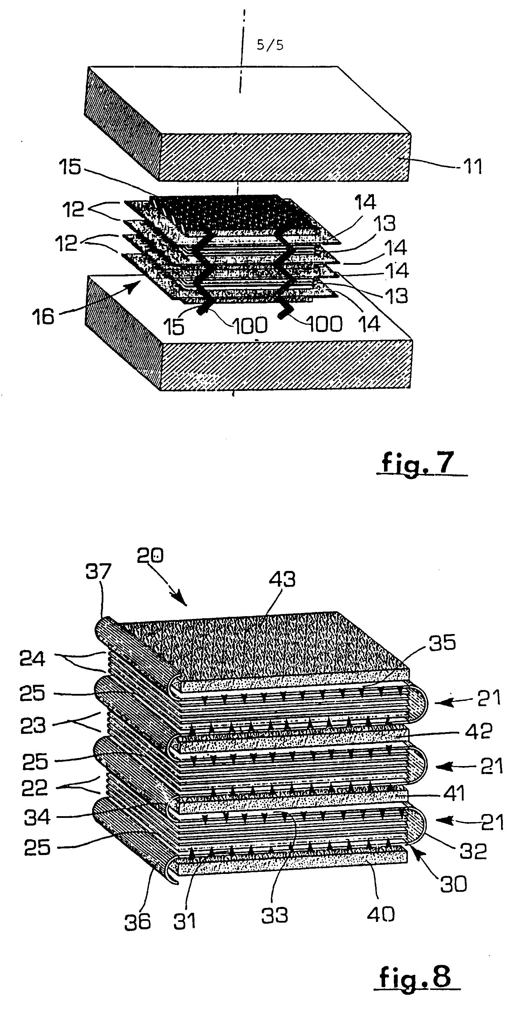

Fig. 7 illustrates one of the present presses drawn in Fig. 1 and marked 10, the lines marked 100 indicating propagation of heat,emitted by the heating plates 11, or of refrigeration units.

Fig. 8 shows the pile of packages seen in Fig. 2, and gives (see the vertical arrows) the lines of propagation of heat emitted by the various lengths 31, 33, 35 of the metal band 30.

## Claims

1. Process for producing plastic laminates with metal laminae, especially for printed circuits, by formation of piles (20,80) of packages (21,81) each comprising a group (22-24) of supporting sheets (25) impregnated with plastic material and with metal laminae on the faces,
characterized in that the metal laminae are obtained from a continuous metal band (30,95) laid at the lower face of the first group (22) of sheets (25) starting from the bottom and above a first metal sheet (40), and then, on making a bend 32 at 180°, it is laid on the upper face of said group (22) and, after a metal sheet (41) has been placed on the band and after the band has made a second bend (34) at 180° in the direction opposite to the first, said band is placed upon the metal sheet (41) and at the lower face of the second group (23) of sheets and then, having made a third bend at 180° in the direction opposite to the second bend, said band is laid on the upper face of this second group (23) of sheets (25) and so on by placing a metal sheet (42,43) between each two consecutive bends of the (metal) band, until the upper face of the last group (24) of sheets (25) has been reached, the two ends (36,37-96,97) of the band (95) being connected to a generator (72,94) of electricity of adequate power so that by generating adequate pressure on the pile (20,80) of packages (21,81) and the eletric circuit of the generator (72,94) having been closed, the various lengths (31) (33) (35) of the band (30,95) matching with the faces of the packages (21,81) act as electric resistances creating close association among the various parts and formation of plastic laminates.

2. Process as in claim 1,
characterized in that the pressure on the pile (20) of packages (21) is obtained by inserting said pile (20) inside a cold press (60).

3. Process as in claim 1,
characterized in that the pressure on the pile (80) of packages is determined by placing said pile (80) inside an autoclave (90).

4. Process as in claim 1,
characterized in that each pile (20) of packages (21) is placed first inside a die (50) with its upper (51) and lower (52) plates connected by pins (53) (54) for support and guidance, it being thus possible to apply the pressure needed for the process onto said die (50).

5. Process as in claim 4,
characterized in that the pressure on the die (50) is obtained by placing it inside a cold press (60).

6. Process as in claim 4,
characterized in that the pressure on the die (50) is obtained by placing it inside an autoclave (90).

7. Process as in claim 1,
characterized in that the band (30) is made of copper.

8. Process as in claims 1
characterized in that the pressure on the pile (80) of packages is determined by placing said pile (80) inside an autoclave (90), the pile (80) of packages put inside it being comprised between a plate (83) fixed to the bottom of the autoclave and a plate (87) fixed to the inside of a lid (91), there being placed on said plates (83, 87) conducting laminae (84, 88) in a position to contact the lower and upper sides of the pile (80) of packages and thus to come in contact with the two ends (96, 97) of the serpentine-wise metal band (95) with which the pile (80) of packages is formed, said laminae (84, 88) being connected with a generator (94) of electricity, the plate (87) being held to the inside of the lid (91) by elastic means (85) so that by closing the lid (91), closure is automatically secured of the circuit between the generator (94) and the metal band (95), thereby enabling the start of the pressing process already described.

## Patentansprüche

1. Verfahren für die Herstellung von Laminaten mit Metallfolien, insbesondere für gedruckte Schaltungen, bei Herstellung von Stapeln (20, 80) von Paketen (21, 81), wobei jeder eine Gruppe (22-24) von Tragplatten (25) umfaßt, die mit Kunststoffmaterial imprägniert sind und Metallfolien an den Oberflächen aufweisen,
dadurch gekennzeichnet, daß die Metallfolien aus einem durchgehenden Metallband (30, 35) gewonnen werden, das an der unteren Oberfläche der ersten Gruppe (22) von Platten (25) verläuft, und zwar ausgehend vom Boden und oberhalb einer ersten Metallplatte (40), und das anschließend durch Vollführung einer Kurve von 180° über die obere Fläche dieser Gruppe (22) ausgebreitet wird, sowie dadurch, daß dieses Band, nachdem eine Metallplatte (41) auf das Band gelegt wurde und nachdem das Band eine zweite Kurve um 180° in der der ersten entgegengesetzten Richtung vollführt hat (34), auf die Metallplatte (41) an der unteren Oberfläche der zweiten Gruppe (23) Platten gelegt wird, und daß anschließend, nach Vollführung einer dritten Kurve um 180° in der der zweiten entgegengesetzten Richtung, dieses Band auf die obere Fläche dieser zweiten Gruppe (23) Platten (25) gelegt wird, und so weiter, wobei eine Metallplatte (42, 43) jeweils zwischen zwei aufeinanderfolgende Bänder des (Metall) Bands geschoben wird, bis die obere Fläche der letzten Gruppe (24) Platten (25) erreicht wird, wobei die beiden Enden (38, 37-98, 97) des Bands (95) an einen Stromerzeuger (72, 94) einer angemessenen Leistung angeschlossen werden, so daß durch die Erzeugung eines entsprechenden Drucks auf den Stapel (20, 80) von Paketen, (21, 81) und da der Schaltkreis des Erzeugers (72, 94) geschlossen wurde, die einzelnen Längen (31) (33) des Bands (30, 95), die sich mit den Oberflächen der Pakete (21, 81) verbinden, als elektrischen Widerstände wirken und eine enge Verbindung zwischen den einzelnen Teilen herstellen und die Bildung von Laminaten zur Folge haben.

2. Verfahren laut Anspruch 1,
dadurch gekennzeichnet, daß der Druck auf den Stapel (20) von Paketen (21) durch Einsetzen dieses Stapels (20) in eine Presse (60) erzielt wird.

3. Verfahren laut Anspruch 1,
dadurch gekennzeichnet, daß der Druck des Stapels (80) von Paketen entsteht, indem man diesen Stapel (80) in einen Druckkessel (90) legt.

4. Verfahren laut Anspruch 1,
dadurch gekennzeichnet, daß der Stapel (20) von Paketen (21) in ein Lager (50) gelegt wird, wobei seine obere (51) und untere Platte (52) durch Stifte (53) (54) für Halterung und Führung verbunden sind, wodurch der für das Verfahren notwendige Druck auf das besagte Lager (50) aufgebracht werden kann.

5. Verfahren laut Anspruch 4,
dadurch gekennzeichnet, daß der Druck auf das Lager (50) erzielt wird, indem man es kalt in eine Presse (60) legt.

6. Verfahren laut Anspruch 4,
dadurch gekennzeichnet, daß der Druck auf das Lager (50) erzielt wird, indem man es in einen Druckkessel (90) legt.

7. Verfahren laut Anspruch 1,
dadurch gekennzeichnet, daß das Band (30) aus Kupfer ist.

8. Verfahren laut Anspruch 1,
dadurch gekennzeichnet, daß der Druck auf die Stapel (80) von Paketen entsteht, indem man diesen Stapel (80) in einen Druckkessel (90) legt, wobei der hineingelegte Stapel (80) von Paketen zwischen einer Platte (83), die am Boden des Druckkessels befestigt ist, und einer Platte (87) liegt, die im Innern eines Deckels (91) befestigt ist, wobei an diesen Platten (83, 87) Leitfolien (84, 88) in einer solchen Stellung liegen, daß die oberen und unteren Seiten des Stapels (80) von Paketen berührt werden und ein Kontakt zwischen den beiden Enden (96, 97) des Schlangen- Metallbands (95) hergestellt wird, aus dem der Stapel (80) von Paketen gebildet wird, wobei diese Folien (84, 88) mit einem Stromerzeuger (94) verbunden sind und die Platte (87) im Innern des Deckels (91) durch Elastikbänder zurückgehalten wird, so daß bei Schließung des Deckels die Schließung der Schaltung automatisch zwischen der Schaltung, dem Erzeuger (94) und dem Metallband (95) gesichert wird, wodurch der Start des bereits beschriebenen Preßvorgangs ermöglicht wird.

## Revendications

1. Procédé pour la production de laminés plastiques avec des lames de métal, en particulier pour les circuits imprimés avec la formation de piles (20, 80) de paquets (21, 81) comprenant chacun un groupe (22 - 24) de plaques de support (25) imprégnées de matière plastique et avec des lames de métal sur les surfaces,
caractérisé par le fait que les lames de métal sont obtenues à partir d'un ruban métallique continu (30, 95) tendu en correspondance de la surface inférieure du premier groupe (22) de plaques (25) à partir du fond et au-dessus d'une première plaque de métal (40), et par conséquent, en faisant un coude (32) à 180°, il est tendu sur la surface supérieure de ce groupe (22) et, après qu'une lame de métal (41) ait été posée sur le ruban et après que le ruban ait fait un second coude (34) à 180° dans la direction opposée à la première, ce ruban est placé sur la plaque métallique (41) en correspondance de la surface inférieure du second groupe (23) de plaques et par conséquent, ayant effectué un troisième coude à 180° en direction opposée au second coude, ce ruban étant tendu sur la surface supérieure de ce second groupe (23) de plaques (25) et ainsi de suite en posant une plaque de métal (42, 43) entre chacun de deux rubans consécutifs du ruban (métallique), jusqu'à ce que la surface supérieure du dernier groupe (24) de plaques (25) ait été atteinte, les deux extrémités (36, 37 - 96, 97) du ruban (95) étant reliées à un générateur (72, 94) d'électricité d'une puissance adaptée de sorte qu'en générant une juste pression sur la pile (20, 80) de paquets (21, 81) et le circuit électrique du générateur (72, 94) ayant été fermé, les différentes longueurs (31) (33) (35) du ruban (30, 95) en se couplant avec les surfaces des paquets (21, 81) font fonction de résistances électriques en créant un couplage étroit entre les différentes parties et la formation de laminés plastiques.

2. Procédé conformément à la revendication 1,
caractérisé par le fait que la pression sur la pile (20) de paquets (21) est obtenue en insérant cette pile (20) dans une presse (60).

3. Procédé conformément à la revendication 1,
caractérisé par le fait que la pression de la pile (80) de paquets est déterminée en posant cette pile (80) dans un autoclave (90).

4. Procédé conformément à la revendication 1,
caractérisé par le fait que la pile (20) de paquets (21) est placée dans un coussinet (50) avec ses plaques supérieure (51) et inférieure (52) reliées au moyen d'axes (53) (54) pour support et guidage, étant ainsi possible d'appliquer la pression nécessaire pour le procédé sur ce coussinet (50).

5. Procédé conformément à la revendication 4,
caractérisé par le fait que la pression sur le coussinet (50) est obtenue en le plaçant à l'intérieur d'une presse à froid (60).

6. Procédé conformément à la revendication 4,
caractérisé par le fait que la pression sur le coussinet (50) est obtenue en le plaçant dans un autoclave (60).

7. Procédé conformément à la revendication 1,
caractérisé par le fait que le ruban (30) est fait en cuivre.

8. Procédé conformément à la revendication 1,
caractérisé par le fait que la pression sur la pile (80) de paquets est déterminée en posant cette pile (80) dans un autoclave (90), la pile (80) de paquets placée à l'intérieur étant entre une plaque (83) fixée au fond de l'autoclave et une plaque (87) fixée à l'intérieur d'un couvercle (91), des lames conductrices (84, 88) étant placées sur ces plaques (83, 87) dans une position telle qu'elles contactent les côtés supérieur et inférieur de la pile (80) de paquets de manière à entrer en contact avec les deux extrémités (98, 97) du ruban métallique (95) à serpentin avec laquelle est formée la pile (80) de paquets, ces lames (84, 88) étant reliées à un générateur (94) d'électricité, la plaque (87) étant retenue à l'intérieur du couvercle (91) par l'intermédiaire de moyens élastiques (85), de sorte qu'en fermant le couvercle (91), la fermeture du circuit est assurée automatiquement entre le circuit le générateur (94) et le ruban métallique (95) en permettant la mise en route du procédé de pressage déjà décrit.
